# EUROPEAN PATENT SPECIFICATION

(11) **EP 3 419 028 B1**
(45) Date of publication and mention of the grant of the patent: **06.01.2021**
(21) Application number: 17753240.5
(22) Date of filing: 15.02.2017
(51) Int. Cl.: H01B 1/22, H01B 1/00, H01B 5/14, H05K 1/09, C22C 5/06, C22C 9/05, C22C 22/00, H01B 1/02, H05K 1/03, H05K 1/18, H05K 3/10, H05K 3/34

(54) **CONDUCTIVE PASTE**
LEITPASTE
PÂTE CONDUCTRICE

(30) Priority: 17.02.2016 JP 2016027753
(43) Date of publication of application: 26.12.2018
(73) Proprietor: Namics Corporation, Niigata-shi, Niigata 950-3131 (JP)
(72) Inventor: YOSHII Yoshiaki, Niigata-shi Niigata 950-3131 (JP)
(74) Representative: Hoffmann Eitle
(86) International application number: PCT/JP2017/005576
(87) International publication number: WO 2017/141984

(56) References cited:
- EP-A1- 1 185 143
- WO-A1-2014/061765
- JP-A- S6 231 190
- JP-A- H09 306 236
- JP-A- 2000 048 645
- JP-A- 2000 048 645
- JP-A- 2001 203 066
- JP-A- 2001 223 065
- JP-U- S5 339 232
- JP-U- S5 339 232
- US-A1- 2014 110 637
- US-A1- 2014 110 637
- US-B1- 6 406 646

## Description

### TECHNICAL FIELD

The present invention relates to a sintering conductive paste which can be used for forming, for example, a conductor pattern of a printed wiring board.

### BACKGROUND ART

A conductive paste in which metal particles are dispersed in a vehicle composed of an organic binder and a solvent has been known. The conductive paste has been used for formation of conductor patterns of printed wiring boards, formation of electrodes of electronic parts, and the like. This type of conductive paste can be roughly divided into a resin curing type and a firing type. The resin curing type conductive paste is a conductive paste in which metal particles are brought into contact with each other by curing of the resin to ensure conductivity. The firing type conductive paste is a conductive paste in which metal particles are sintered with each other by firing to ensure conductivity.

As metal particles contained in the conductive paste, for example, a copper powder or a silver powder is used. The copper powder has an advantage that it has excellent conductivity and is inexpensive as compared with a silver powder. However, the copper powder tends to be oxidized in the air atmosphere, so there is a disadvantage that, for example, after forming a conductor pattern on a substrate, the surface of the conductor pattern must be coated with a protective material. On the other hand, the silver powder is stable in the atmosphere, and it has an advantage that a conductor pattern can be formed by firing in the air atmosphere, but there is a disadvantage that electromigration easily occurs.

As a technique for preventing electromigration, Patent Document 1 discloses a conductive paint comprising a silver powder as a main conductive material, characterized by containing 1 to 100 parts by mass of a powder of manganese and/or manganese alloy based on 100 parts by mass of the silver powder. Patent Document 2 discloses a conductive paste comprising a binder resin, an Ag powder, and at least one metal or metal compound selected from the group consisting of Ti, Ni, In, Sn, and Sb.

However, the conductive pastes disclosed in Patent Documents 1 and 2 have insufficient adhesion to a substrate and solder heat resistance, and there was a problem in practicality for use in forming a conductor pattern on a substrate.

Therefore, as a technique for improving solder heat resistance of a conductive paste, Patent Document 3 discloses a conductive paste characterized in that a silver powder is coated with a material containing a first metal component for suppressing sintering of silver and a second metal component for promoting sintering of silver.

However, although the conductive paste disclosed in Patent Document 3 improves the solder heat resistance somewhat, the sinterability of silver is suppressed, so that there is a problem that the conductivity of the conductor pattern obtained by firing the conductive paste deteriorates. In addition, since a step of coating the surface of the silver powder with the metal material is required, there is a problem that the production process becomes complicated.

Patent Document 4 describes a photosensitive conductive paste which comprises conductive metal fine particles and a photosensitive organic component as essential component and wherein at least one metal fine particle is selected from the group of Ru, Cr, Fe, Co, Mn and Cu. The paste is applied to a substrate and is baked to form a conductor film having a specified thickness.

Patent Document 5 describes a hot plate that uses a ceramic substrate provided with a conductive layer. The conductive layer includes ruthenium oxide, glass frit and noble metal grains.

### PRIOR ART DOCUMENTS

### Patent Documents

Patent Document 1: JP Sho. 55-149356A
Patent Document 2: JP 2003-115216A
Patent Document 3: JP 2006-196421A
Patent Document 4: JP 2000-048645 A
Patent Document 5: EP 1 185 143 A1

### SUMMARY OF THE INVENTION

### Problems to be Solved by the Invention

An object of the present invention is to provide a sintering conductive paste which is excellent in solder heat resistance and adhesion to a substrate.

### Means to Solve the Problems

The inventors of the present invention conducted extensive research on a sintering conductive paste which is excellent in solder heat resistance and adhesion to a substrate. As a result, it was found that it is effective to add to a conductive paste a powder containing an oxide of a platinum group element and/or a compound which can be an oxide of a platinum group element, in addition to a silver powder, a glass frit, and an organic binder, so that the present invention was completed.

The present invention is as follows.
(1) A conductive paste which is as defined in claim 1. Preferred features are described in the dependent claims.
(2) A printed wiring board, an electronic device, a ceramic electronic part and a ceramic body with a metal layer as defined in the claims.

### Effects of the Invention

According to the present invention, it is possible to provide a sintering conductive paste which is excellent in solder heat resistance and adhesion to a substrate.

### BRIEF DESCRIPTION OF THE DRAWINGS

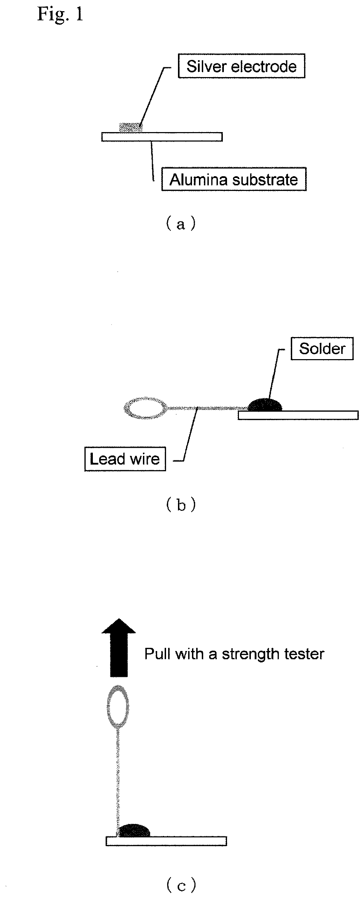

Fig. 1 shows a procedure of an adhesion strength test.

### EMBODIMENTS TO CARRY OUT THE INVENTION

Embodiments for carrying out the present invention will be described in detail below.

The conductive paste according to the embodiment of the present invention comprises:
(A) a silver powder;
(B) a glass frit;
(C) an organic binder, and
(E) a powder containing an oxide of a platinum group element and/or a compound which can be an oxide of a platinum group element.

### (A) Silver powder

The conductive paste of the present invention comprises (A) a silver powder as conductive particles. As the silver powder in the present invention, a powder comprising silver or an alloy containing silver can be used. The shape of the silver powder particles is not particularly limited, and for example, spherical, granular, flake-shaped, or scaly silver powder particles can be used.

The average particle diameter of the silver powder used in the present invention is preferably from 0.1 µm to 100 µm, more preferably from 0.1 µm to 20 µm, and most preferably from 0.1 µm to 10 µm. The average particle diameter referred to herein means a volume-based median diameter (d50) obtained by a laser diffraction/scattering particle size distribution measurement method.

In order for the conductive paste to exhibit high conductivity, it is preferable to increase the particle diameter of the silver powder contained in the conductive paste. However, if the particle diameter of the silver powder is too large, applicability to a substrate and workability of the conductive paste are impaired. Therefore, it is preferable to use a silver powder having a large particle diameter as long as the applicability to a substrate and the workability of the conductive paste are not impaired. Considering these facts, it is preferable that the average particle diameter of the silver powder used in the present invention is within the above range.

The method for producing the silver powder is not particularly limited, and it can be produced by, for example, a reduction method, a pulverization method, an electrolysis method, an atomization method, a heat treatment method, or a combination thereof. The flaky silver powder can be produced, for example, by crushing spherical or granular silver particles with a ball mill or the like.

### (B) Glass frit

The conductive paste of the present invention comprises (B) a glass frit. Since the conductive paste contains the glass frit, adhesion to a substrate of a conductor pattern obtained by firing the conductive paste is improved. The glass frit to be used in the present invention is not particularly limited, and a glass frit preferably having a softening point of 300°C or higher, more preferably a softening point of 400 to 1000°C, and further preferably a softening point of 400 to 700°C can be used. The softening point of the glass frit can be measured using a thermogravimetric apparatus (for example, TG-DTA 2000 SA manufactured by Bruker AXS).

Specific examples of a glass frit can include a bismuth borosilicate type, an alkali metal borosilicate type, an alkaline earth metal borosilicate type, a zinc borosilicate type, a lead borosilicate type, a lead borate type, a lead silicate type, a bismuth borate type or a zinc borate type glass frit. The glass frit is preferably lead-free from the viewpoint of environmental consideration, and examples thereof can include a bismuth borosilicate type and an alkali metal borosilicate type glass frit.

The glass frit preferably contains bismuth(III) oxide (Bi₂O₃). When the glass frit contains bismuth(III) oxide, a softening point of the glass frit is lowered, and flowability of the glass frit at the time of melting is increased. As a result, sinterability of the conductive paste is increased, and a dense sintered body can be obtained when the conductive paste is sintered. In the glass frit, the content of bismuth(III) oxide (Bi₂O₃) is preferably 70 to 95% by mass in terms of oxide. Further, it is preferable that the glass frit is a bismuth borosilicate type. The glass frit preferably contains 70 to 95 % by mass of bismuth(III) oxide (Bi₂O₃), 3 to 15 % by mass of boron oxide (B₂O₃) and 2 to 15 % by mass of silicon oxide (SiO₂) in terms of oxide, respectively. When the content is within this range, a glass frit having a suitable softening point can be obtained.

In addition, when the glass frit contains bismuth(III) oxide (Bi₂O₃), adhesion between a sintered body obtained by sintering the conductive paste and an alumina substrate is enhanced. The reason for the high adhesion is presumed to be that the bismuth(III) oxide contained in the glass frit reacts with alumina contained in the substrate.

The average particle diameter of the glass frit is preferably 0.1 to 20 µm, more preferably 0.2 to 10 µm, and most preferably 0.5 to 5 µm. The term "average particle diameter" as used herein means a volume-based median diameter (d50) obtained by a laser diffraction/scattering particle size distribution measurement method.

In the conductive paste of the present invention, the content of the glass frit (B) is preferably from 0.01 to 20 parts by mass, and more preferably from 0.1 to 10 parts by mass, based on 100 parts by mass of the silver powder (A). When the content of the glass frit is less than this range, adhesion to a substrate of a conductor pattern obtained by firing the conductive paste is reduced. On the contrary, when the content of the glass frit is larger than this range, conductivity of a conductor pattern obtained by firing the conductive paste deteriorates.

### (C) Organic binder

The conductive paste of the present invention comprises (C) an organic binder. The organic binder in the present invention is one that binds silver powder particles to each other in the conductive paste and is burned off during firing of the conductive paste. As the organic binder, although not particularly limited, for example, a thermosetting resin or a thermoplastic resin can be used.

As the thermosetting resin, for example, an epoxy resin, a urethane resin, a vinyl ester resin, a silicone resin, a phenol resin, a urea resin, a melamine resin, an unsaturated polyester resin, a diallyl phthalate resin, a polyimide resin, or the like can be used.

As the thermoplastic resin, for example, cellulose resin such as ethyl cellulose and nitrocellulose, acrylic resin, alkyd resin, saturated polyester resin, butyral resin, polyvinyl alcohol, hydroxypropyl cellulose and the like can be used.

These resins may be used singly or in combination of two or more thereof.

In the conductive paste of the present invention, the content of the organic binder (C) is preferably from 0.5 to 30 parts by mass, and more preferably from 1.0 to 10 parts by mass, based on 100 parts by mass of the silver powder (A).

When the content of the organic binder (C) in the conductive paste is within the above range, applicapability of the conductive paste to a substrate is improved, and a fine pattern can be formed with high accuracy. On the other hand, when the content of the organic binder (C) exceeds the above range, the amount of the organic binder contained in the conductive paste is too large, so that denseness of a conductor pattern obtained after firing may decrease.

### (D) Powder containing copper and/or manganese

The conductive paste of the present invention may contain (D) a powder containing copper and/or manganese. The powder (D) may be a mixed powder of metals containing copper and/or manganese. Alternatively, the powder (D) may be an alloy powder containing copper and/or manganese. Alternatively, the powder (D) may be a compound powder containing copper and/or manganese.

The mixed powder of metals including copper and/or manganese is a mixed powder containing at least one of copper, copper alloy, manganese and manganese alloy.

The alloy powder containing copper and/or manganese is a powder of an alloy containing at least one of copper and manganese.

The compound powder containing copper and/or manganese is a powder containing at least one of a copper compound and a manganese compound.

The powder (D) may contain an oxide or a hydroxide of copper and/or manganese. That is, the powder (D) may contain at least one of copper oxide, copper hydroxide, manganese oxide, and manganese hydroxide.

The powder (D) may be a powder containing copper, tin, and manganese. In this case, the powder (D) may be a mixed powder of metals including copper, tin, and manganese. Alternatively, the powder (D) may be an alloy powder containing copper, tin, and manganese. Alternatively, the powder (D) may be a compound powder containing copper, tin, and manganese.

The mixed powder of metals including copper, tin, and manganese is a mixed powder containing copper or a copper alloy, tin or a tin alloy, and manganese or a manganese alloy.

The alloy powder containing copper, tin, and manganese is a powder of an alloy containing copper, tin, and manganese.

The compound powder containing copper, tin, and manganese is a powder containing a copper compound, a tin compound, and a manganese compound.

The copper, tin, and manganese contained in the powder (D) may be a simple metal or an oxide thereof, respectively. For example, copper may be a simple metal (Cu) or an oxide (e.g. CuO). Tin may be a simple metal (Sn) or an oxide (e.g. SnO). Manganese may be a simple metal (Mn) or an oxide (such as MnO₂).

The copper, tin, and manganese contained in the powder (D) may be a compound (e.g. a hydroxide) which turns into an oxide upon firing of the conductive paste. For example, the powder (D) may contain Cu(OH)₂. The powder (D) may contain Sn(OH)₂. The powder (D) may contain Mn(OH)₂.

Since the simple metal of manganese has a very high hardness, it is difficult to obtain a metal powder having a uniform particle diameter. Therefore, manganese is preferably in the form of an oxide (for example, MnO₂) or an alloy.

The content of the powder (D) contained in the conductive paste of the present invention is preferably from 0.1 to 5.0 parts by mass, more preferably from 0.2 to 3 parts by mass, and further preferably from 1.0 to 3.0 parts by mass, based on 100 parts by mass of the silver powder (A).

When the content of the (D) powder containing copper and/or manganese in the conductive paste is within the above range, electromigration resistance, solder heat resistance and adhesion to a substrate of the conductive paste are improved.

The content of copper (Cu) in terms of element contained in the conductive paste of the present invention is preferably from 0.005 to 2.85 parts by mass, and more preferably from 0.015 to 2 parts by mass, based on 100 parts by mass of the silver powder (A).

The content of tin (Sn) in terms of element contained in the conductive paste of the present invention is preferably from 0.0025 to 2.85 parts by mass, more preferably from 0.015 to 1 part by mass, and further preferably from 0.02 to 0.075 parts by mass, based on 100 parts by mass of the silver powder (A).

The content of manganese (Mn) in terms of element contained in the conductive paste of the present invention is preferably from 0.005 to 2.85 parts by mass, and more preferably from 0.015 to 2 parts by mass, based on 100 parts by mass of the silver powder (A).

When the content of copper contained in the conductive paste of the present invention is regarded as 1, the content of tin in terms of element is preferably from 0.01 to 0.3 in mass ratio.

When the content of copper contained in the conductive paste of the present invention is regarded as 1, the content of manganese in terms of element is preferably from 0.01 to 2.5 in mass ratio.

Adjustment of the contents of copper, tin, and manganese within the above ranges further improves electromigration resistance, solder heat resistance, and adhesion to a substrate of the conductive paste. In addition, when the conductive paste contains copper, tin, and manganese, solder wettability of the conductive paste is improved as compared with the case where only two components thereof are contained.

### (E) Powder containing an oxide of a platinum group element and/or a compound which can be an oxide of a platinum group element

The conductive paste of the present invention comprises (E) a powder containing an oxide of a platinum group element and/or a compound which can be an oxide of a platinum group element.

The platinum group element is, for example, at least one element selected from the group consisting of ruthenium, rhodium, palladium, osmium, iridium and platinum.

The platinum group element is preferably at least one element selected from the group consisting of ruthenium, platinum, palladium, and iridium.

The platinum group element is more preferably ruthenium.

The powder (E) may contain an oxide of a platinum group element.

The oxide of the platinum group element is, for example, an oxide of at least one element selected from the group consisting of ruthenium, platinum, palladium, and iridium. An example of such an oxide is ruthenium(IV) oxide (RuO₂).

The powder (E) may contain a compound which can be an oxide of a platinum group element. The compound which can be an oxide of a platinum group element means a compound which can be converted into an oxide of a platinum group element by heat during firing of the conductive paste. However, the "compound" here includes not only a compound composed of a platinum group element and another element but also a simple substance of a platinum group element.

The powder (E) includes, for example, ruthenium(IV) oxide (RuO₂), and/or a compound which can be converted to ruthenium(IV) oxide (RuO₂) by heat during firing of the conductive paste.

When the conductive paste contains both the powder (D) and the powder (E), solder heat resistance and adhesion to a substrate of the conductive paste are remarkably improved.

The content of the (E) powder containing an oxide of a platinum group element and/or a compound which can be an oxide of a platinum group element contained in the conductive paste of the present invention is from 0.5 to 3.0 parts by mass, more preferably from 0.5 to 2.0 parts by mass, and further preferably from 1.0 to 1.5 parts by mass, based on 100 parts by mass of the silver powder (A).

The SEM diameter of the (E) powder containing an oxide of a platinum group element and/or a compound which can be an oxide of a platinum group element is preferably from 0.01 µm to 10 µm, and more preferably from 0.01 µm to 5 µm. The SEM diameter referred to here means an average of values obtained by measuring a total of 500 particles using SEM (Scanning Electron Microscope) under the following conditions: magnification: × 50,000, the number of observed field of view: 5, the number of particles to be measured: 100 particles per field of view. The SEM diameter of one particle is obtained from a circle equivalent diameter of a particle image obtained by SEM.

When the content of the powder (E) in the conductive paste is within the above range, solder heat resistance and adhesion to a substrate of the conductive paste are remarkably improved.

### (F) Powder of bismuth(III) oxide

The conductive paste of the present invention may further contain (F) a powder of bismuth(III) oxide (Bi₂O₃). When the conductive paste contains the (F) powder of bismuth(III) oxide, sintering of the silver powder contained in the conductive paste is promoted. As a result, solder wettability of a conductor pattern obtained by sintering the conductive paste is improved.

In the conductive paste of the present invention, the content of the (F) powder of bismuth(III) oxide is preferably from 0.01 to 5.0 parts by mass, more preferably from 0.1 to 3.0 parts by mass, and further preferably from 0.1 to 1.0 parts by mass, based on 100 parts by mass of the silver powder (A).

The conductive paste of the present invention may contain a solvent for viscosity adjustment or the like.

Examples of the solvent include alcohols such as methanol, ethanol and isopropyl alcohol (IPA), organic acids such as ethylene acetate, aromatic hydrocarbons such as toluene and xylene, N-alkyl pyrrolidones such as N-methyl-2-pyrrolidone (NMP), amides such as N,N-dimethylformamide (DMF), ketones such as methyl ethyl ketone (MEK), terpineol (TEL), butyl carbitol (BC), water and the like.

The content of the solvent is not particularly limited, and is preferably from 1 to 100 parts by mass, and more preferably from 5 to 60 parts by mass based on 100 parts by mass of the silver powder (A).

The viscosity of the conductive paste of the present invention is preferably 50 to 700 Pa·s, and more preferably 100 to 300 Pa·s. When the viscosity of the conductive paste is adjusted within this range, applicability to a substrate and handling of the conductive paste are improved, and the conductive paste can be applied to a substrate with a uniform thickness.

The conductive paste of the present invention may contain other additives such as dispersants, rheology modifiers, pigments and the like.

The conductive paste of the present invention may further contain an inorganic filler (for example, fumed silica, calcium carbonate, talc and the like), a coupling agent (for example, a silane coupling agent such as γ-glycidoxypropyltrimethoxysilane, a titanate coupling agent such as tetraoctyl bis (ditridecyl phosphite)titanate, etc.), a silane monomer (for example, tris(3-(trimethoxysilyl)propyl)isocyanurate), a plasticizer (for example, a copolymer such as a carboxyl group-terminated polybutadiene-acrylonitrile, a silicone rubber, a silicone rubber powder, a silicone resin powder, a resin powder such as an acrylic resin powder, etc.), a flame retardant, an antioxidant, a defoamer etc.

The conductive paste of the present invention can be produced by mixing the above-mentioned respective components using, for example, a grinding mixer, a pot mill, a three roll mill, a rotary mixer, a twin screw mixer or the like.

Next, a method of forming a conductor pattern on a substrate using the conductive paste of the present invention will be described.

First, the conductive paste of the present invention is applied on a substrate. The application method is arbitrary, and it can be applied by a known method such as dispensing, jet dispensing, stencil printing, screen printing, pin transfer, stamping, or the like.

After applying the conductive paste on a substrate, the substrate is put into an electric furnace or the like. Then, the conductive paste applied on the substrate is fired at 500 to 900°C, more preferably 600 to 900°C, and further preferably 700 to 900°C. As a result, the silver powder particles contained in the conductive paste are sintered with each other, and components such as an organic binder contained in the conductive paste are burned off.

The conductor pattern obtained in this way has very high conductivity. In addition, the conductor pattern obtained in this manner is excellent in solder heat resistance and adhesion to a substrate.

The conductive paste of the present invention can be used for forming a circuit of an electronic part, forming an electrode, joining an electronic part to a substrate, or the like. For example, the conductive paste of the present invention can be used for forming a conductor circuit of a printed wiring board and forming an external electrode of a multilayer ceramic capacitor. In these applications, since parts, lead wires and the like are soldered to the conductor pattern formed using the conductive paste, it is possible to make good use of the favorable solder heat resistance of the conductive paste of the present invention. By using the conductive paste of the present invention, it is possible to manufacture a printed wiring board and an electronic device excellent in electrical characteristics.

By using the conductive paste of the present invention, it is possible to form a conductor pattern on a substrate. This conductor pattern has high solder heat resistance and is excellent in adhesion to a substrate. Further, by soldering an electronic part onto a printed wiring board on which the conductor pattern has been formed, an electronic device can be manufactured. The electronic device manufactured in this way has high reliability and excellent electrical characteristics.

A ceramic electronic part can be produced by applying the conductive paste of the present invention to a ceramic body and then firing the conductive paste. For example, after applying the conductive paste of the present invention to a multilayer ceramic body (a laminate of a ceramic dielectric and an internal electrode), this conductive paste is fired to form an external electrode of a multilayer ceramic capacitor. The conductive paste applied to the ceramic body can be fired at 500 to 900°C, more preferably 600 to 900°C, and further preferably 700 to 900°C. By this procedure, the silver powder particles contained in the conductive paste are sintered with each other, and components such as an organic binder contained in the conductive paste are burned off.

By using the conductive paste of the present invention, an external electrode of a multilayer ceramic capacitor can be formed. This external electrode has high solder heat resistance and is excellent in adhesion to a ceramic body. The multilayer ceramic capacitor produced in this way has high reliability and excellent electrical characteristics.

By using the conductive paste of the present invention, a ceramic body with a metal layer can be produced. The ceramic body with a metal layer comprises a ceramic body and a metal layer joined to at least a part of the surface of the ceramic body. The metal layer contains silver as its main component and contains a glass. The metal layer contains an oxide of a platinum group element and/or a compound which can be an oxide of a platinum group element. It is preferable that the metal layer further contains bismuth. It is preferable that the platinum group element contained in the metal layer is contained in an oxide state. The platinum group element is preferably at least one element selected from the group consisting of ruthenium, platinum, palladium, and iridium. More preferably, the platinum group element is ruthenium. The ceramic body is, for example, a multilayer ceramic body (a laminate of a ceramic dielectric and an internal electrode). The metal layer is, for example, an external electrode of a multilayer ceramic capacitor.

### EXAMPLES

In the following, examples of the present invention and comparative examples will be described.

### [Materials of conductive paste]

The following components (A) to (F) were mixed in the proportions shown in in Examples 1 to 12 and Comparative Example 1, described in the following Tables 1 and 2, to prepare conductive pastes. The proportions of the respective components shown in Tables 1 and 2 are all shown in parts by mass.

### (A) silver powder

Spherical silver powder having an average particle diameter of 2.5 µm prepared by a wet reduction method.

### (B) glass frit

Bi₂O₃·B₂O₃ type glass frit having an average particle diameter (D50) of 5.2 µm and a softening point of 440°C.

### (C) organic binder

An organic binder prepared by dissolving an ethyl cellulose resin in butyl carbitol was used. The mixing ratio of the ethyl cellulose resin and butyl carbitol is 20:80 (mass ratio). As the ethyl cellulose resin, an ethyl cellulose resin in which ethyl cellulose having the ethoxylation degree of 48% or more occupies 80% or more and the remaining is ethyl cellulose having the ethoxylation degree of 45 to 47% was used.

### (D) powder containing copper and/or manganese

### (D-1) alloy powder containing copper, manganese, and tin

Spherical alloy powder having a composition (mass ratio) of Cu: Mn: Sn = 90.5: 7.0: 2.5 and an average particle diameter of 3 µm produced by a gas atomizing method.

### (D-2) alloy powder containing copper and manganese

Spherical alloy powder having a composition (mass ratio) of Cu: Mn = 90: 10 and an average particle diameter of 3 µm produced by a gas atomizing method.

### (D-3) powder of copper(II) oxide (CuO)

Powder having an average particle diameter of 1 µm.

### (D-4) Powder of manganese(IV) oxide (MnO₂)

Powder having an average particle diameter of 1 µm.

(E) powder containing an oxide of a platinum group element and/or a compound which can be an oxide of a platinum group element
(E-1) powder of ruthenium(IV) oxide (RuO₂), SEM diameter: 0.5 µm
(E-2) powder of iridium(IV) oxide (IrO₂), SEM diameter: 0.5 µm
(E-3) powder of palladium(II) oxide (PdO), SEM diameter: 5 µm
(E-4) powder of platinum(IV) oxide (PtO₂), SEM diameter: 5 µm

### (F) bismuth oxide powder

Bi₂O₃ powder having an average particle diameter of 3 µm

### [Preparation of test piece]

A test piece was prepared by the following procedures.

First, a conductive paste was applied on an alumina substrate of 20 mm × 20 mm × 1 mm (t) by screen printing. By this procedure, 25 patterns were formed on the alumina substrate, in which each pattern is composed of square pad shape with a side of 1.5 mm. For forming the pattern, a 250 mesh mask made of stainless steel was used. Next, the conductive paste was dried at 150°C for 10 minutes using a hot air dryer. After drying the conductive paste, the conductive paste was fired using a firing furnace. The firing temperature is 850°C (maximum temperature), and the firing time is 30 minutes.

### [Solder heat resistance test]

The specimens prepared above were immersed in a lead-free solder bath for 30 seconds, 40 seconds and 50 seconds, respectively, and then the specimens were pulled up. The corner pad pattern remaining on the alumina substrate was photographed with a camera, and the photographed image was digitally processed. By this procedure, the ratio (%) of the area of the remaining corner pad pattern was determined. When the ratio of the area of the remaining corner pad pattern was 95% or more, it was judged that the solder heat resistance was very good (O). When the ratio of the area of the remaining corner pad pattern was 80% or more, it was judged that the solder heat resistance was good (Δ). When the ratio of the area of the remaining corner pad pattern was less than 80%, it was judged that the solder heat resistance was not good (×). The temperature of the lead-free solder bath was set at 250°C. The composition of the solder used for the lead-free solder bath is Sn-3.0Ag-0.5Cu (Senju Metal Industry Co., Ltd., M 705).

The results of the solder heat resistance test are shown in the following Tables 3 and 4.

### [Adherence strength test]

(1) A conductive paste was applied on an alumina substrate of 20 mm × 20 mm × 1 mm (t) by screen printing. By this procedure, a pattern having a square pad shape with a side of 1.5 mm was formed (Fig. 1(a)). For forming the pattern, a 250 mesh mask made of stainless steel was used.
(2) Next, the conductive paste was dried at 150°C for 10 minutes using a hot air dryer. After drying the conductive paste, the conductive paste was fired using a firing furnace. The firing temperature is 850°C (maximum temperature), and the firing time is 30 minutes.
(3) Lead wire (tin-plated annealed copper wire 0.8 mmϕ) was joined to the pattern obtained by the firing in the above (2) using a soldering iron (Fig. 1(b)). For joining, lead-free solder was used. The composition of the solder used is Sn-3.0Ag-0.5Cu (Senju Metal Industry Co., Ltd., M 705).
(4) The lead wire joined to the pattern in the above (3) was pulled by a strength tester in the direction perpendicular to the substrate, and the tensile strength (N) when the lead wire was peeled from the joining portion was measured (Fig. 1c)). The measurement was carried out ten times, and the average of 10 measurement values was calculated.
(5) The alumina substrate was allowed to stand for 100 hours in a drier maintained at 150°C, and then the same test as in the above (4) was carried out. Further, the same tests were conducted by changing the standing time to 250 hours, 500 hours, and 1000 hours.
(6) The alumina substrate was allowed to stand in a heat cycle testing machine for 250 cycles, and then the same test as in the above (4) was carried out. The temperature range for one cycle is -40 to 125°C. The holding time at -40°C and 125°C in one cycle is 30 minutes each. Also, the same tests were conducted by changing the number of cycles to 500 cycles and 1000 cycles.

The results of the adhesion strength test (high temperature storage test and heat cycle test) are shown in the following Tables 5 and 6.

**[Table 1]**

| | Example 1 | Example 2 | Example 3 | Example 4 | Example 5 | Example 6 | Example 7 |
|---|---|---|---|---|---|---|---|
| (A) Silver powder | 100 | 100 | 100 | 100 | 100 | 100 | 100 |
| (B) Glass frit | 0.3 | 0.3 | 0.3 | 0.3 | 0.3 | 0.3 | 0.3 |
| (C) Organic binder | 9.0 | 9.0 | 9.0 | 9.0 | 9.0 | 9.0 | 9.0 |
| (D-1) CuMnSn alloy powder | 2.5 | 2.5 | 2.5 | 2.5 | 2.5 | 2.5 | 2.5 |
| (D-2) CuMn alloy powder | | | | | | | |
| (D-3) CuO powder | | | | | | | |
| (D-4) MnO₂ powder | | | | | | | |
| (E-1) RuO₂ powder | 0.5 | 1.0 | 1.5 | 2.0 | | | |
| (E-2) IrO₂ powder | | | | | 1.5 | | |
| (E-3) PdO powder | | | | | | 1.5 | |
| (E-4) PtO₂ powder | | | | | | | 1.5 |
| (F) Bismuth oxide powder | 0.3 | 0.3 | 0.3 | 0.3 | 0.3 | 0.3 | 0.3 |

**[Table 2]**

| | Example 8 | Example 9 | Example 10 | Example 11 | Example 12 | Comparative Example 1 |
|---|---|---|---|---|---|---|
| (A) Silver powder | 100 | 100 | 100 | 100 | 100 | 100 |
| (B) Glass frit | 0.3 | 0.3 | 0.3 | 0.3 | 0.3 | 0.3 |
| (C) Organic binder | 9.0 | 9.0 | 9.0 | 9.0 | 9.0 | 9.0 |
| (D-1) CuMnSn alloy powder | | | | | 2.5 | 2.5 |
| (D-2) CuMn alloy powder | | 2.5 | | | | |
| (D-3) CuO powder | | | 2.5 | | | |
| (D-4) MnO₂ powder | | | | 2.5 | | |
| (E-1) RuO₂ powder | 1.5 | 1.5 | 1.5 | 1.5 | 1.5 | 0.0 |
| (E-2) IrO₂ powder | | | | | | |
| (E-3) PdO powder | | | | | | |
| (E-4) PtO₂ powder | | | | | | |
| (F) Bismuth oxide powder | 0.3 | 0.3 | 0.3 | 0.3 | 0.0 | 0.3 |

**[Table 3]**

| Solder heat resistance test (250°C) | | | | | | | |
|---|---|---|---|---|---|---|---|
| | Example 1 | Example 2 | Example 3 | Example 4 | Example 5 | Example 6 | Example 7 |
| 30 sec. | ○ | ○ | ○ | ○ | ○ | ○ | ○ |
| 40 sec. | ○ | ○ | ○ | ○ | ○ | Δ | Δ |
| 50 sec. | ○ | ○ | ○ | ○ | ○ | Δ | Δ |

**[Table 4]**

| Solder heat resistance test (250°C) | | | | | | |
|---|---|---|---|---|---|---|
| | Example 8 | Example 9 | Example 10 | Example 11 | Example 12 | Comparative Example 1 |
| 30 sec. | ○ | ○ | ○ | ○ | ○ | × |
| 40 sec. | ○ | ○ | ○ | ○ | ○ | × |
| 50 sec. | ○ | ○ | ○ | ○ | ○ | × |

**[Table 5]**

| Adhesion strength test | | | | | | | | |
|---|---|---|---|---|---|---|---|---|
| | | Example 1 | Example 2 | Example 3 | Example 4 | Example 5 | Example 6 | Example 7 |
| High Temperature storage | Initial | 26.4 | 27.8 | 29.0 | 29.5 | 28.5 | 28.4 | 28.2 |
| | After 100 hours | 25.1 | 26.4 | 27.4 | 28.2 | 27.6 | 27.1 | 27.0 |
| | After 250 hours | 24.2 | 25.1 | 25.8 | 27.4 | 25.5 | 25.3 | 25.2 |
| | After 500 hours | 23.6 | 24.5 | 25.1 | 26.3 | 25.0 | 24.8 | 24.6 |
| | After 1000 hours | 22.8 | 23.0 | 23.6 | 24.2 | 23.4 | 23.3 | 23.0 |
| Heat cycle | Initial | 26.4 | 27.8 | 29.0 | 29.5 | 28.5 | 28.4 | 28.2 |
| | 100 cycles | 21.0 | 22.5 | 22.9 | 23.4 | 22.8 | 22.6 | 22.4 |
| | 250 cycles | 20.4 | 21.7 | 22.1 | 23.1 | 21.9 | 21.8 | 21.6 |
| | 500 cycles | 16.7 | 17.0 | 17.4 | 18.4 | 17.3 | 17.2 | 17.1 |
| | 1000 cycles | 14.4 | 14.6 | 15.5 | 16.7 | 15.4 | 15.2 | 15.1 |

**[Table 6]**

| Adhesion strength test | | | | | | | |
|---|---|---|---|---|---|---|---|
| | | Example 8 | Example 9 | Example 10 | Example 11 | Example 12 | Comparative Example 1 |
| High temperature storage | Initial | 22.2 | 27.0 | 23.8 | 24.4 | 23.3 | 23.2 |
| | After 100 hours | 20.4 | 25.4 | 22.4 | 23.2 | 22.1 | 22.9 |
| | After 250 hours | 18.9 | 24.3 | 22.3 | 22.7 | 21.5 | 21.5 |
| | After 500 hours | 18.2 | 22.6 | 20.7 | 21.3 | 20.0 | 21.0 |
| | After 1000 hours | 16.9 | 22.1 | 19.9 | 20.2 | 19.3 | 20.1 |
| Heat cycle | Initial | 22.2 | 27.0 | 23.8 | 24.4 | 23.3 | 23.2 |
| | 100 cycles | 17.8 | 22.9 | 20.4 | 21.0 | 20.0 | 20.5 |
| | 250 cycles | 16.7 | 21.1 | 19.6 | 20.0 | 19.3 | 18.5 |
| | 500 cycles | 14.5 | 17.4 | 16.4 | 16.3 | 15.7 | 16.5 |
| | 1000 cycles | 12.7 | 14.5 | 14.1 | 13.8 | 13.4 | 14.0 |

As can be seen from the results shown in Tables 3 to 6, the conductor patterns obtained by firing the conductive pastes of Examples 1 to 12 were excellent in solder heat resistance and adhesion to a substrate. In contrast, the conductor pattern obtained by firing the conductive paste of Comparative Example 1 was poor in solder heat resistance and adhesion to a substrate.

## Claims

1. A conductive paste comprising the following components (A), (B), (C) and (E):
(A) a silver powder;
(B) a glass frit;
(C) an organic binder, and
(E) a powder containing an oxide of a platinum group element and/or a compound which can be an oxide of a platinum group element,
wherein the content of the powder (E) is 0.5 to 3.0 parts by mass based on 100 parts by mass of the silver powder (A), and
either (a) the glass frit (B) is a glass frit containing bismuth (III) oxide, or
(b) the conductive paste further comprises (D) a powder containing copper and/or manganese.

2. The conductive paste according to claim 1, wherein the platinum group element is at least one selected from the group consisting of ruthenium, platinum, palladium, and iridium, and wherein the platinum group element is preferably ruthenium.

3. The conductive paste according to any one of claim 1 or 2 , wherein the paste of (a) further comprises (D) a powder containing copper and/or manganese.

4. The conductive paste according to claim 1 or 3, wherein the powder (D) is selected from the following embodiments (i), (ii) and (iii):
(i) a mixed powder of metals containing copper and/or manganese;
(ii) an alloy powder containing copper and/or manganese; and
(iii) a compound powder containing copper and/or manganese.

5. The conductive paste according to claim 4, wherein the powder (D) contains an oxide or a hydroxide of copper and/or manganese.

6. The conductive paste according to any one of claim 1 to 3, further comprising (D) a powder containing copper and/or manganese, wherein the powder (D) is preferably selected from the following embodiments (a), (b) and (c):
(a) a mixed powder of metals including copper, tin, and manganese;
(b) an alloy powder containing copper, tin, and manganese; and
(c) a compound powder containing copper, tin, and manganese.

7. The conductive paste according to claim 6, wherein the powder (D) contains an oxide or a hydroxide of at least one of copper, tin, and manganese.

8. The conductive paste according to any one of claim 1 to 7, further comprising (F) a powder of bismuth(III) oxide.

9. A printed wiring board obtainable by applying the conductive paste according to any one of claim 1 to 8 on a substrate and then firing the substrate at 500 to 900°C.

10. An electronic device obtainable by soldering an electronic part on the printed wiring board according to claim 9.

11. A ceramic electronic part obtainable by applying the conductive paste according to any one of claim 1 to 10 to a ceramic body and then firing the ceramic body at 500 to 900°C.

12. A ceramic body with a metal layer, comprising a ceramic body and a metal layer joined to at least a part of a surface of the ceramic body,
wherein
the metal layer contains silver as a main component and a glass,
the metal layer contains an oxide of a platinum group element and/or a compound which can be an oxide of a platinum group element, in an amount of 0.5 to 3.0 parts by mass based on 100 parts by mass of the silver, and wherein either
(a) the glass contains bismuth (III) oxide, or
(b) the metal layer further comprises (D) copper and/or manganese.

13. The ceramic body with a metal layer according to claim 12, wherein the metal layer further contains bismuth.

14. The ceramic body with a metal layer according to claim 12, wherein the platinum group element is at least one selected from the group consisting of ruthenium, platinum, palladium and iridium, and wherein the platinum group element is preferably ruthenium.

## Patentansprüche

1. Leitende Paste, enthaltend die folgenden Komponenten (A), (B), (C) und (E):
(A) ein Silberpulver,
(B) eine Glasfritte,
(C) ein organisches Bindemittel und
(E) ein Pulver, das ein Oxid eines Elementes der Platingruppe und/oder eine Verbindung enthält, die ein Oxid eines Elementes der Platingruppe sein kann,
worin der Gehalt des Pulvers (E) 0,5 bis 3,0 Masseteile ist, bezogen auf 100 Masseteile des Silberpulvers (A), und
entweder (a) die Glasfritte (B) eine Glasfritte mit Wismut(III)oxid ist oder
(b) die leitende Paste weiterhin (D) ein Pulver enthält, das Kupfer und/oder Mangan enthält.

2. Leitende Paste gemäß Anspruch 1, worin das Element der Platingruppe zumindest eines ist, ausgewählt aus der Gruppe, bestehend aus Ruthen, Platin, Palladium und Iridium und worin das Element der Platingruppe bevorzugt Ruthen ist.

3. Leitende Paste gemäß einem der Ansprüche 1 oder 2, worin die Paste von (a) weiterhin (D) ein Pulver enthält, das Kupfer und/oder Mangan enthält.

4. Leitende Paste gemäß Anspruch 1 oder 3, worin das Pulver (D) ausgewählt ist aus den folgenden Merkmalen (i), (ii) und (iii):
(i) ein gemischtes Pulver von Metallen, das Kupfer und/oder Mangan enthält,
(ii) ein Legierungspulver, das Kupfer und/oder Mangan enthält und
(iii) ein Verbindungspulver, das Kupfer und/oder Mangan enthält.

5. Leitende Paste gemäß Anspruch 4 worin das Pulver (D) ein Oxid oder Hydroxid von Kupfer und/oder Mangan enthält.

6. Leitende Paste gemäß einem der Ansprüche 1 bis 3, weiterhin enthaltend (D) ein Pulver, das Kupfer und/oder Mangan enthält, worin das Pulver (D) bevorzugt ausgewählt ist aus den folgenden Merkmalen (a), (b) und (c) :
(a) ein gemischtes Pulver von Metallen, enthaltend Kupfer, Zinn und Mangan,
(b) ein Legierungspulver, enthaltend Kupfer, Zinn und Mangan, und
(c) ein Verbindungspulver, enthaltend Kupfer, Zinn und Mangan.

7. Leitende Paste gemäß Anspruch 6, worin das Pulver (D) ein Oxid oder ein Hydroxid von zumindest einem von Kupfer, Zinn und Mangan enthält.

8. Leitende Paste gemäß einem der Ansprüche 1 bis 7, weiterhin enthaltend (F) ein Pulver von Wismut(III)oxid.

9. Gedruckte Schaltplatte, erhältlich durch Auftragen der leitenden Paste gemäß einem der Ansprüche 1 bis 8 auf ein Substrat und anschließendes Feuern des Substrates bei 500 bis 900°C.

10. Elektronische Vorrichtung, erhältlich durch Löten eines elektronischen Teils auf der gedruckten Schaltplatte gemäß Anspruch 9.

11. Elektronisches Keramikteil, erhältlich durch Auftragen der leitenden Paste gemäß einem der Ansprüche 1 bis 10 auf einen Keramikkörper und anschließendes Brennen des Keramikkörpers bei 500 bis 900°C.

12. Keramikkörper mit einer Metallschicht, enthaltend einen Keramikkörper und eine Metallschicht, die an zumindest einem Teil einer Oberfläche des Keramikkörpers gebunden ist, worin
die Metallschicht Silber als Hauptkomponente und ein Glas enthält,
die Metallschicht ein Oxid aus einem Element der Platingruppe und/oder eine Verbindung, die ein Oxid eines Elementes der Platingruppe sein kann, in einer Menge von 0,5 bis 3,0 Masseteilen enthält, bezogen auf 100 Masseteilen Silber und worin entweder
(a) das Glas Wismut(III)oxid enthält oder
(b) die Metallschicht weiterhin (D) Kupfer und/oder Mangan enthält.

13. Keramikkörper mit einer Metallschicht gemäß Anspruch 12, worin die Metallschicht weiterhin Wismut enthält.

14. Keramikkörper mit einer Metallschicht gemäß Anspruch 12, worin das Element der Platingruppe zumindest eines ist, ausgewählt aus der Gruppe, bestehend aus Ruthen, Platin, Palladium und Iridium und worin das Element der Platingruppe bevorzugt Ruthen ist.

## Revendications

1. Pâte conductrice comprenant les composants (A), (B), (C) et (E) suivants :
(A) une poudre d'argent ;
(B) une fritte de verre ;
(C) un liant organique, et
(E) une poudre contenant un oxyde d'un élément de groupe platine et/ou un composé qui peut être un oxyde d'un élément de groupe platine,
dans laquelle la teneur en poudre (E) est de 0,5 à 3,0 parties en masse sur la base de 100 parties en masse de la poudre d'argent (A), et
soit (a) la fritte de verre (B) est une fritte de verre contenant de l'oxyde de bismuth (III), soit
(b) la pâte conductrice comprend en outre (D) une poudre contenant du cuivre et/ou du manganèse.

2. Pâte conductrice selon la revendication 1, dans laquelle l'élément de groupe platine est au moins un choisi dans le groupe constitué du ruthénium, du platine, du palladium et de l'iridium, et dans laquelle l'élément de groupe platine est de préférence du ruthénium.

3. Pâte conductrice selon l'une quelconque des revendications 1 ou 2, dans laquelle la pâte de (a) comprend en outre (D) une poudre contenant du cuivre et/ou du manganèse.

4. Pâte conductrice selon la revendication 1 ou 3, dans laquelle la poudre (D) est choisie parmi les modes de réalisation (i), (ii) et (iii) suivants :
(i) une poudre mélangée de métaux contenant du cuivre et/ou du manganèse ;
(ii) une poudre d'alliage contenant du cuivre et/ou du manganèse, et
(iii) une poudre composée contenant du cuivre et/ou du manganèse.

5. Pâte conductrice selon la revendication 4, dans laquelle la poudre (D) contient un oxyde ou un hydroxyde de cuivre et/ou de manganèse.

6. Pâte conductrice selon l'une quelconque des revendications 1 à 3, comprenant en outre (D) une poudre contenant du cuivre et/ou du manganèse, dans laquelle la poudre (D) est de préférence choisie parmi les modes de réalisation (a), (b) et (c) suivants :
(a) une poudre mélangée de métaux incluant du cuivre, de l'étain et du manganèse ;
(b) une poudre d'alliage contenant du cuivre, de l'étain et du manganèse ; et
(c) une poudre composée contenant du cuivre, de l'étain et du manganèse.

7. Pâte conductrice selon la revendication 6, dans laquelle la poudre (D) contient un oxyde ou un hydroxyde d'au moins un parmi cuivre, étain et manganèse.

8. Pâte conductrice selon l'une quelconque des revendications 1 à 7, comprenant en outre (F) une poudre d'oxyde de bismuth (III).

9. Carte de circuit imprimé pouvant être obtenue en appliquant la pâte conductrice selon l'une quelconque des revendications 1 à 8 sur un substrat et en faisant ensuite cuire le substrat à une température de 500 à 900 °C.

10. Dispositif électronique pouvant être obtenu en soudant une pièce électronique sur la carte de circuit imprimé selon la revendication 9.

11. Pièce électronique en céramique pouvant être obtenue en appliquant la pâte conductrice selon l'une quelconque des revendications 1 à 10 à un corps en céramique et en faisant ensuite cuire le corps céramique à une température de 500 à 900 °C.

12. Corps en céramique avec une couche métallique, comprenant un corps en céramique et une couche métallique assemblés à au moins une partie d'une surface du corps en céramique,
dans lequel
la couche métallique contient de l'argent en tant que composant principal et un verre,
la couche métallique contient un oxyde d'un élément de groupe platine et/ou un composé qui peut être un oxyde d'un élément de groupe platine, dans une quantité de 0,5 à 3,0 parties en masse sur la base de 100 parties en masse de l'argent, et dans lequel soit
(a) le verre contient de l'oxyde de bismuth (III), soit
(b) la couche métallique comprend en outre (D) du cuivre et/ou du manganèse.

13. Corps en céramique avec une couche métallique selon la revendication 12, dans lequel la couche métallique contient en outre du bismuth.

14. Corps en céramique avec une couche métallique selon la revendication 12, dans lequel l'élément de groupe platine est au moins un choisi dans le groupe constitué du ruthénium, du platine, du palladium et de l'iridium, et dans lequel l'élément de groupe platine est de préférence du ruthénium.
